# EUROPEAN PATENT APPLICATION

(11) **EP 4 761 560 A1**
(43) Date of publication of application: **17.06.2026**
(21) Application number: 25224040.3
(22) Date of filing: 16.12.2025
(51) Int. Cl.: H10W 70/40, H10W 40/77, H10W 74/10, H10W 74/01, H10W 72/60, H10W 40/22

(54) **A METHOD OF MANUFACTURING A SEMICONDUCTOR PACKAGE AND SUCH SEMICONDUCTOR PACKAGE**

(30) Priority: 16.12.2024 MY PI2024007268
(71) Applicant: Nexperia B.V., 6534 AB Nijmegen (NL)
(72) Inventor: Ting, Jia Yunn, Seremban (MY); Chang, Ting Wei, Seremban (MY); Lee, Wai Wai, Seremban (MY); Poelma, Regnerus Hermannus, 6534 AB Nijmegen (NL)
(74) Representative: Pjanovic, Ilija

(57) **Abstract**

A method of manufacturing a semiconductor package assembly and a semiconductor package is provided, with integral electrically conductive layers seeded on the first die side and on the part of the at least one lead frame terminal.

## Description

### Technical Field

The present disclosure relates to a method of manufacturing a semiconductor package and such semiconductor package. More precisely, the present invention is directed to new dual side cooling package concept.

### Background

Existing dual-side cooling packages, wherein both the top and bottom surfaces are utilized for thermal dissipation, incorporate a die mounted to a die frame (paddle), with this die frame being exposed at the bottom of the package. A copper heat slug is soldered to the top of the die, and it remains exposed after encapsulation, either through grinding or a Film-Assisted Molding (FAM) process. This conventional design necessitates the use of a customized copper heat slug, tailored to the die front metallization area (FMA), which imposes high stamping tooling costs, prolonged conversion times during the assembly process (including heat slug changes and heat slug singulation tool exchanges), and complicated inventory management.

To enhance thermal dissipation, certain copper heat slugs have been designed using dual-gauge materials, where copper is rolled into different thicknesses within a single cross-section. While effective, this approach incurs costs that are three to four times higher than conventional heat slugs. Additionally, the attachment of the heat slug requires stringent assembly controls to mitigate potential issues, such as heat slug misalignment, exposed heat slug surfaces, and solder voids beneath the heat slug, all of which contribute to yield loss.

Moreover, the package design necessitates multiple solder connections, specifically between the die top and the heat slug, as well as between the heat slug and the lead.

These solder interfaces introduce increased package resistance, resulting in compromised thermal and electrical performance.

### Summary

It would be advantageous to achieve a semiconductor package without any customized heat slug, to optimize cost, simplifies production and optimizes performance.

According to the first aspect of the present disclosure, there is provided a method of manufacturing a semiconductor package assembly comprising the steps of:
a) providing a lead frame having a first frame side and a second frame side opposite to the first frame side as well as at least one lead frame terminal;
b) providing at least one semiconductor die structure having a first die side and a second die side opposite to the first die side with its second die side on the first frame side of the lead frame;
c) encapsulating at least part of the lead frame, the semiconductor die structure and the at least one lead frame terminal with a moulding resin;
d) removing a portion of the moulding resin thereby exposing at least part of the first die side of at least one die structure;
e) providing an electrical connection layer between the exposed first die side and the exposed part of the at least one lead frame terminal;
wherein step e) comprises at least the sub-steps of:
e1) applying a seeding layer of a first electrically conductive material on the first die side and on the part of the at least one lead frame terminal;
e2) applying a cover layer of a second electrically conductive material as a finish of the electrical connection layer.

The inventors have found that it may be beneficial to use electrically conductive layers provided in process of manufacturing a semiconductor package assembly instead of using a customized heat slug. It should be noted that the method also enables the realization of a dual side cooled configuration.

This approach introduces enhanced flexibility to the manufacturing process, enabling compatibility with various die FMA configurations without necessitating the use of costly customized copper heat slugs. The omission of a heat slug attachment additionally contributes to a significant reduction in overall package thickness, supporting the development of more compact semiconductor designs.

In an example of the disclosure the first electrically conductive material is copper.

In an example of the disclosure the second conductive material is tin.

In an example of the disclosure the seeding layer is applied using at least one process selected from the group consisting of seeding, spraying, printing, sputtering, electroless plating.

A further advantage of this solution is this it mitigates thermal and electrical performance losses by providing direct deposition of the electrically conductive layers onto the die and lead frame terminals. The layer parameters obtained with these technologies not only allow the process to remain flexible, but also provide a suitable structure and layer thickness that can successfully replace a standard heat slug in performance. Moreover, failure modes associated with solder fatigue or wirebond degradation are addressed through the implementation of direct metallic bonding at the interfaces between the seeding layer and the die surface.

In an example of the disclosure step e1) comprises the step of applying a copper filling made of sintered paste, or solder printing on top of the seeding layer.

In an example of the disclosure step e1) comprises the step of applying one or more copper pillars on top of the copper filling.

Advantageously this invention can further extend to higher voltage application such as silicon carbide (SiC), gallium nitride (GaN), module where conductive material such as copper paste or solder can be applied on TIP surface to enhanced thermal dissipation.

In an example of the disclosure the cover layer is applied using a plating process selected from the group consisting of galvanic plating process, electro plating process, electroless plating process.

In an example of the disclosure step c) of encapsulating comprises the step of forming a depression in the encapsulant at the first die side.

The inventors have found that it may be beneficial to design a mold body (the encapsulant) with visible step (the depression) near die top. There is no need for grinding or polishing, which mechanical process increase stress on the die. Due to the multi-step shape of the mould, it is possible to reduce the time and energy required in the laser opening process for the laser to hit the die surface.

In an example of the disclosure step d) of removing comprises the step of cleaning the exposed first die side and removing mold flashes from the semiconductor package.

In an example of the disclosure step d) comprises removing a portion of the moulding resin thereby exposing part of the at least one lead frame terminal.

In an example of the disclosure the method comprising a step of singulating the semiconductor package from the lead frame;
The disclosure also relates to a semiconductor package comprising at least one semiconductor die connected with at least one first conductive terminal surrounded by an encapsulant, wherein the semiconductor package has an upper side and a bottom side, and further comprising a seeding layer and cover layer according to the method of the disclosure.

A particular benefit of this semiconductor package design is the absence of a customized heat slug. The manufacturing process of the electrically conductive layers makes the package cheaper, the flexible process makes it easier to carry out design changes, and there is no need for a clip either. By excluding the need for a heat slug and clip, the overall package can be thinner and more cost effectively fabricated. The proposed design change also contributes to the reduction of thermal and electrical losses by providing direct deposition of conductive layers on the die and terminals of the lead frame.

### Brief description of the figures

Fig. 1 depicts steps of a method of manufacturing a semiconductor package, with electrically conductive layers on top of each other.
Fig. 2 depicts steps of a method of manufacturing a semiconductor package with a copper filling made of sintered paste between electrically conductive layers.
Fig. 3 depicts a semiconductor package, with electrically conductive layers on top of each other.
Fig. 4 depicts a semiconductor package with a copper filling made of sintered paste between electrically conductive layers.
Fig. 5 depicts a semiconductor package with a copper filling made of sintered paste and copper pillars between electrically conductive layers.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected", "coupled" or any variant thereof means any connection, either direct or indirect, between two or more elements; the connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

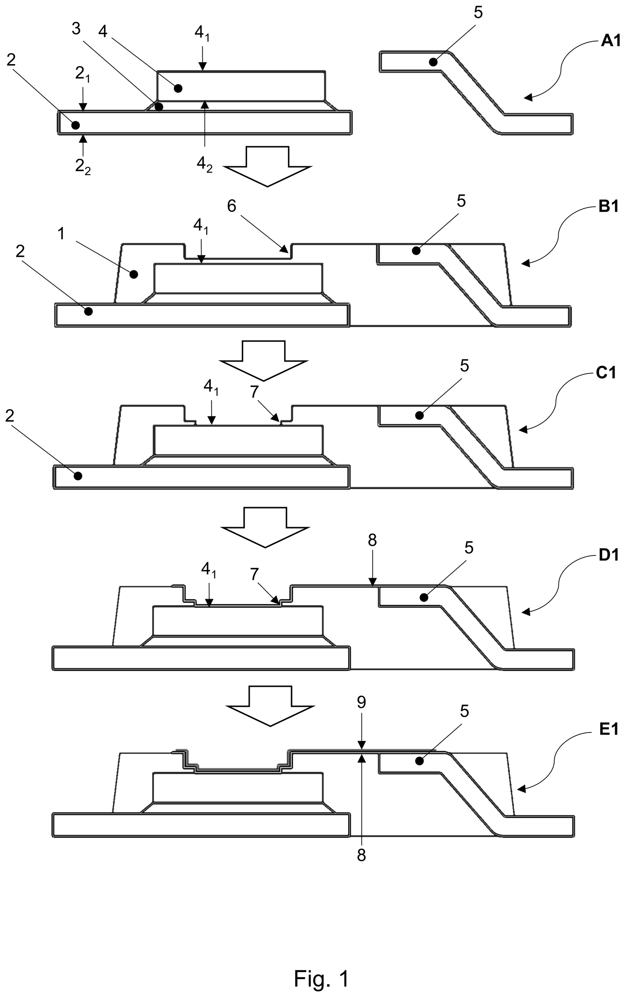

Fig. 1 shows the method depicted in five steps from A1 to E1 step.

Step A1 comprises providing a lead frame 2, a lead frame terminal 5, a semiconductor die 4 structure. The lead frame 2 has a first frame side 2₁ and a second frame side 2₂ opposite to the first frame side 2₁. The semiconductor die 4 structure has a first die side 4₄ and a second die side 4₂ opposite to the first die side 4₁ with its second die side 4₂ on the first frame side 2₁ of the lead frame 2. The semiconductor die structure 4 in this step of the method is placed on the lead frame 2 and soldered (solder material 3) to the first frame side 2₁ - a heat slug/clip attachment in not used. In other embodiments, the die 4 attach material can also be epoxy resin, silver sinter or others. This can makes the package Pb-free and more environmentally sustainable. To be more precise, a lead frame 2 is a frame consisting of a central die pad where a die 4 is placed, typically surrounded by 1 or more leads.

Step B1 comprises encapsulating part of the lead frame 2, the semiconductor die structure 4 and the lead frame terminal 5 with a moulding resin. It also comprises a step of forming a depression 6 in an encapsulant 1 at the first die side 4₁. The encapsulant 1 is designed with a visible step (a depression 6) near the first die side 4₁, targeting 50~100µm from the FMA. Step C1 comprises removing by laser a portion of the moulding resin 1 thereby exposing a part of the first die side 4₁ - creating a die opening 7. The lead frame terminal 5 is exposed already. In other examples where the lead frame terminal 5 is not exposed, the removal step may also apply to the terminal surface. The step of removing comprises a step of cleaning the exposed first die side 4₁ and removing mold flashes from the semiconductor package. The chemical deflashing or electrolytic deflashing is applied to clean the first die side 4₁ opened by laser, and remove mold flashes from the package body.

Step D1 comprises applying a copper seeding layer 8 on the first die side 4₁. By applying electromagnetic interference shielding concept, a thin selective copper layer of about 0.05µm is applied to connect the die opening 7 to the lead frame terminal 5. This can be done either through the sputtering, the spraying, the printing or the electroless process. Next, through the electro plating process, a 20µm copper plating is applied on top of the first copper layer. For designs that require sinter paste or solder, the copper plating layer can be further reduced. This forms the seeding layer 8.

Step E1 comprises applying a tin cover layer 9 on the seeding layer and singulating. The cover layer 9 is formed in process of tin plating. A tin plating with a thickness in the range of 5-20µm is applied on top of the seeding layer 8 in process of plating selected from the group consisting of galvanic plating process, electro plating process, electroless plating process. The final stage of the method is singulating. Package is singulated from leadframe form to loose units. Singulation can be done through trimming for leaded package, or package saw, or laser saw for leadless package.

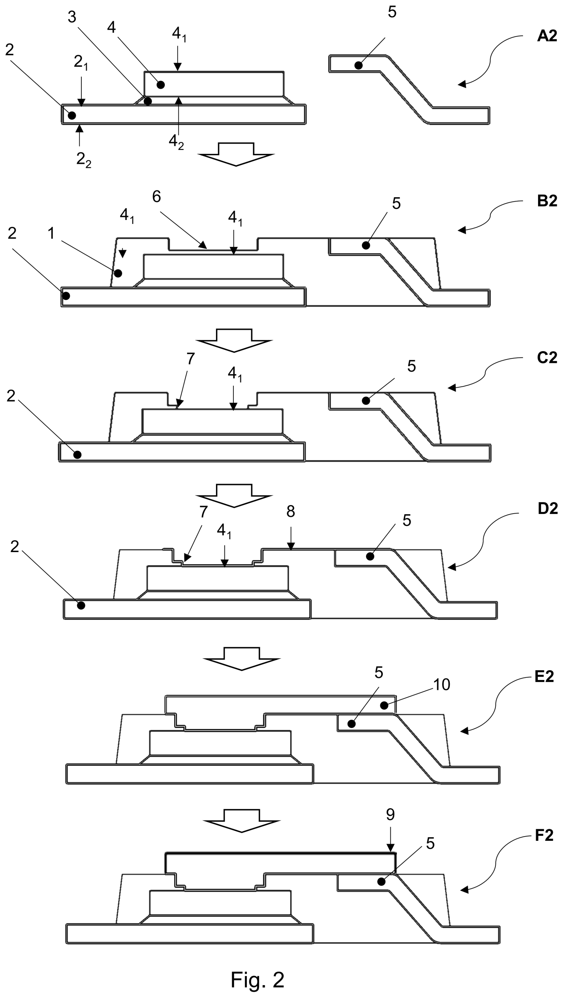

Fig. 2 shows the method depicted in six steps from A2 to F2 step, wherein steps A2 to C2 are this same as steps A1 to C1 of the method disclosed in Fig. 1.

Step D2 comprises applying a copper seeding layer 8 on the first die side 4₁ in the process of copper spraying. This approach can eliminate the seeding process or the need for a copper plating process which can be costly, and avoid copper buildup on the lead frame 2. After copper spraying, thermal curing is required to ensure bonding and adhesion of the seeding layer 8 with the metal and non-conductive layer.

Step E2 comprises copper paste filling 10 and sintering (or solder filling and reflowing) for thermal and electrical enhancement and mechanical planarization.

In another embodiment, additional copper pillars 11 can be made for further thermal reinforcement for very high voltage applications.

Step F2 is similar to the Step E1 of the method disclosed in Fig. 1. A tin plating with a thickness in the range of 5-20µm is applied on top of the copper filling 10 in the process of plating selected from the group consisting of galvanic plating process, electro plating process, electroless plating process. The final stage of the method is singulating.

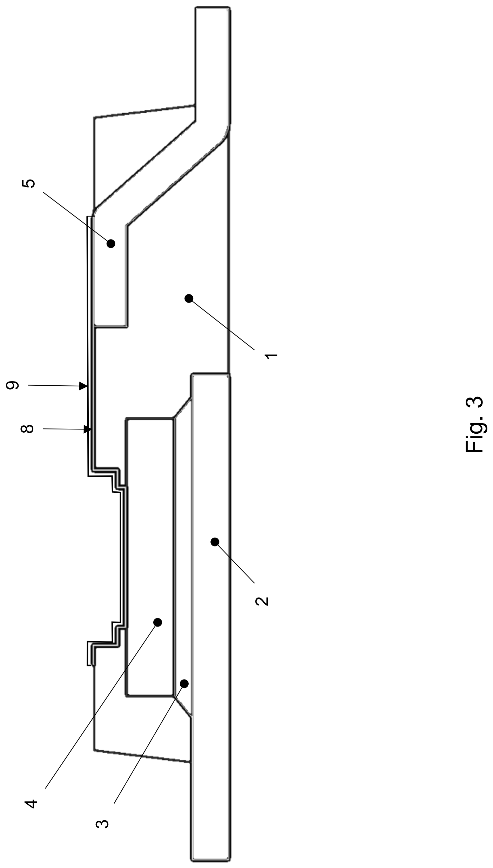

Fig. 3 depicts a semiconductor package comprising a semiconductor die 4 connected with a lead frame terminal 5 surrounded by the encapsulant 1, wherein the semiconductor package has an upper side and a bottom side, and further comprising a seeding layer 8 and cover layer 9 manufactured according to the method in Fig.1.

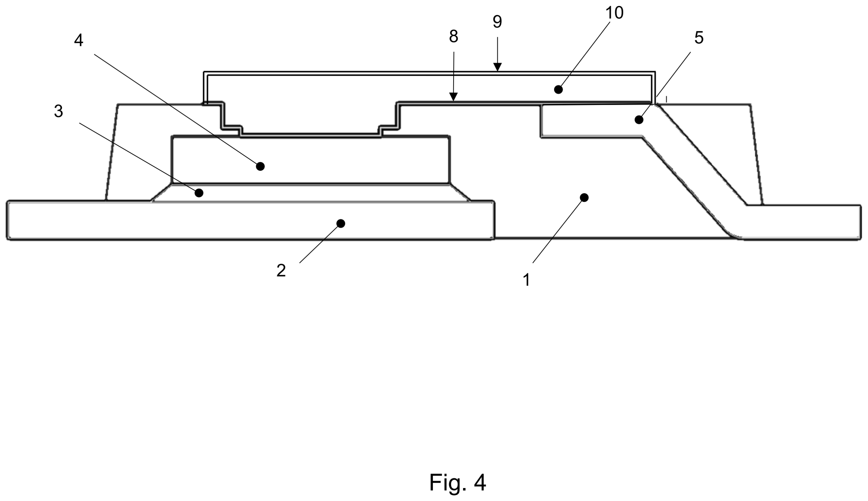

Fig. 4 depicts a semiconductor package comprising a semiconductor die 4 connected with a lead frame terminal 5 surrounded by the encapsulant 1, wherein the semiconductor package has an upper side and a bottom side, and further comprising a seeding layer 8, a flat copper filling 10 and a cover layer 9 manufactured according to the method in Fig.2.

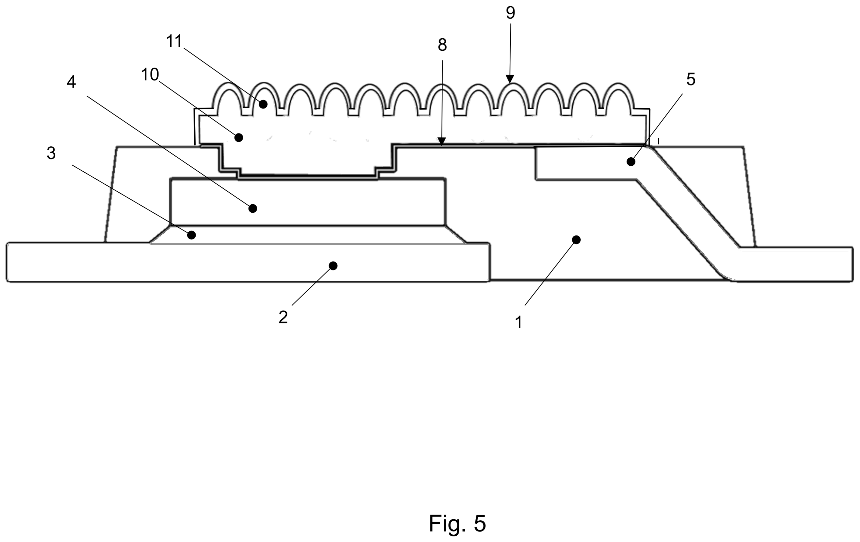

Fig. 5 depicts a semiconductor package comprising a semiconductor die 4 connected with a lead frame terminal 5 surrounded by the encapsulant 1, wherein the semiconductor package has an upper side and a bottom side, and further comprising a seeding layer 8, a copper filling 10 with a copper pillars 11 and a cover layer 9.

Accordingly, the actual scope of the disclosure encompasses not only the disclosed examples, but also all equivalent ways of practicing or implementing a preferred exemplary embodiment of the disclosure, it being understood that various changes may be made in the function and arrangement of elements, including combinations of features from different embodiments, without departing from the scope of the disclosure.

### LIST OF REFERENCE NUMERALS USED

- 1: encapsulant
- 2: lead frame
- 2₁: first frame side
- 2₂: second frame side
- 3: solder material
- 4: die structure
- 4₁: first die side
- 4₂: second die side
- 5: terminal
- 6: depression
- 7: die opening
- 8: seeding layer
- 9: cover layer
- 10: filling
- 11: pillars

## Claims

1. A method of manufacturing a semiconductor package assembly comprising the steps of:
a) providing a lead frame having a first frame side and a second frame side opposite to the first frame side as well as at least one lead frame terminal;
b) providing at least one semiconductor die structure having a first die side and a second die side opposite to the first die side with its second die side on the first frame side of the lead frame;
c) encapsulating at least part of the lead frame, the semiconductor die structure and the at least one lead frame terminal with a moulding resin;
d) removing a portion of the moulding resin thereby exposing at least part of the first die side of at least one die structure;
e) providing an electrical connection layer between the exposed first die side and the exposed part of the at least one lead frame terminal,
wherein step e) comprises at least the sub-steps of:
e1) applying a seeding layer of a first electrically conductive material on the first die side and on the part of the at least one lead frame terminal;
e2) applying a cover layer of a second electrically conductive material as a finish of the electrical connection layer.

2. The method according to claim 1, wherein the first electrically conductive material is copper.

3. The method according to anyone of claim 1 or 2, wherein the second electrically conductive material is tin.

4. The method according to anyone of claim 1-3, wherein the seeding layer is applied using at least one process selected from the group consisting of seeding, spraying, printing, sputtering, electroless plating.

5. The method according to anyone of claim 1-4, wherein step e1) comprises the step of applying a copper filling made of sintered paste, or solder printing on top of the seeding layer.

6. The method according to anyone of claim 5, wherein step e1) comprises the step of applying one or more copper pillars on top of the copper filling.

7. The method according to anyone of claim 1-6, wherein the cover layer is applied using a plating process selected from the group consisting of galvanic plating process, electro plating process, electroless plating process.

8. The method according to anyone of claim 1-7, wherein step c) of encapsulating comprises the step of forming a depression in the encapsulant at the first die side.

9. The method according to anyone of claim 1-8, wherein step d) of removing comprises the step of cleaning the exposed first die side and removing mold flashes from the semiconductor package.

10. The method according to anyone of claim 1-9, wherein step d) comprises removing a portion of the moulding resin thereby exposing part of the at least one lead frame terminal.

11. The method according to anyone of claim 1-10, wherein the method comprising a step of singulating the semiconductor package from the lead frame;

12. A semiconductor package comprising at least one semiconductor die connected with at least one first lead frame terminal surrounded by an encapsulant, wherein the semiconductor package has an upper side and a bottom side, and further comprising a seeding layer and cover layer applied with the method according to anyone of claims 1-11.
